# DEMANDE DE BREVET EUROPEEN

(11) **EP 4 730 953 A1**
(43) Date de publication de la demande: **22.04.2026**
(21) Numéro de dépôt: 25208805.9
(22) Date de dépôt: 15.10.2025
(51) Int. Cl.: H10D 30/66, H10D 62/10, H10D 8/01, H10D 8/60, H10D 62/85, H10P 14/20

(54) **PROCÉDÉ DE FABRICATION DE DISPOSITIFS MICROÉLECTRONIQUES VERTICAUX À BASE DE GAN**

(30) Priorité: 16.10.2024 FR 2411189
(71) Demandeur: Commissariat à l'Energie Atomique et aux Energies Alternatives, 75015 Paris (FR)
(72) Inventeur: BUCKLEY, Julien, 38054 GRENOBLE Cedex 09 (FR); CHARLES, Matthew, 38054 GRENOBLE Cedex 09 (FR); BISCARRAT, Jérôme, 38054 GRENOBLE Cedex 09 (FR); KALTSOUNIS, Thomas, 38054 GRENOBLE Cedex 09 (FR); GODIGNON, Philippe, 38054 GRENOBLE Cedex 09 (FR); EL AMRANI, Mohammed, 38054 GRENOBLE Cedex 09 (FR); PLAZA ARGUELLO, David, 38054 GRENOBLE Cedex 09 (FR); EL RAMMOUZ, Hala, 38054 GRENOBLE Cedex 09 (FR)
(74) Mandataire: Hautier IP

(57) **Abrégé**

L'invention concerne un procédé de fabrication d'au moins un dispositif microélectronique (1a, 1b, 2a, 2b) comprenant la fourniture d'un substrat (10) et la réalisation d'une épitaxie localisée de nitrure de gallium (GaN) sur le substrat, de sorte à former au moins un îlot (100a, 100b) à base de GaN, chaque îlot comprenant une couche de migration (130a, 130b) à base de GaN. Le procédé comprend en outre, au niveau de chaque îlot (100a, 100b), une étape de formation d'une première couche (110a, 110b) à base de GaN dopé d'un premier type (p ou n), la première couche (110a, 110b) formant une pluralité de puits dopés séparés les uns des autres, et une étape de formation d'un drain relié électriquement à chaque îlot (100a, 100b), formant ainsi au moins un transistor vertical (1a, 1b).

## Description

### DOMAINE TECHNIQUE

La présente invention concerne le domaine des dispositifs microélectroniques, notamment les composants à base de GaN. Elle trouve par exemple pour application particulièrement avantageuse le domaine de l'électronique de puissance.

### ETAT DE LA TECHNIQUE

Les principaux dispositifs microélectroniques, et notamment les transistors et les diodes, peuvent être conçus selon de nombreuses architectures de transistors, parmi lesquelles les dispositifs microélectroniques verticaux. Les propriétés des transistors verticaux par exemple sont aujourd'hui particulièrement exploitées dans les applications d'électronique de puissance.

Les dispositifs verticaux à base de GaN sont typiquement fabriqués par épitaxie à partir de substrats GaN. Cependant, les substrats GaN disponibles dans l'industrie sont de faible diamètre. Les procédés actuels de fabrication de dispositifs verticaux GaN sur substrat GaN ne permettent donc pas de fabriquer simultanément une quantité de dispositifs comparable à ce qui est réalisé sur des substrats de plus grand diamètre (substrats silicium typiquement). Ces procédés sont par ailleurs très coûteux du fait du prix élevé des substrats GaN.

Un objectif de la présente invention est ainsi de proposer un procédé de fabrication de dispositifs verticaux à base de GaN résolvant au moins certains des problèmes évoqués ci-dessus.

### RESUME

Pour atteindre cet objectif, un premier aspect de l'invention concerne un procédé de fabrication d'au moins un dispositif microélectronique comprenant les étapes suivantes :
- fournir un substrat présentant une face supérieure,
- réaliser une épitaxie localisée de nitrure de gallium (GaN) sur la face supérieure du substrat, de sorte à former au moins un îlot à base de GaN, chaque îlot présentant une face, dite inférieure, tournée au regard de la face supérieure du substrat, chaque îlot comprenant une couche dite de migration à base de GaN, la couche de migration présentant une face inférieure tournée au regard de la face supérieure du substrat et une face supérieure opposée à la face inférieure,
- au niveau de chaque îlot, former une première couche à base de GaN dopé d'un premier type pris parmi un dopage de type n et un dopage de type p, la première couche formant une pluralité de puits dopés séparés les uns des autres et s'étendant chacun depuis la face supérieure de la couche de migration,
- former une couche électriquement conductrice formant un drain, le drain étant relié électriquement à la face inférieure de chaque îlot, formant ainsi au moins un transistor vertical.

Ainsi, le procédé selon l'invention permet d'initier la formation des dispositifs sur un substrat de grande dimension et peu coûteux, tel qu'un substrat silicium. On évite ainsi d'avoir recours à un substrat GaN coûteux et de faible dimension. Les étapes de formation de grilles, contacts sources, anodes ou autres éléments habituels peuvent être réalisées alors que les îlots reposent sur le substrat, ou bien après retrait de ce substrat. La formation du drain en face arrière nécessite simplement de retirer préalablement le substrat par meulage et/ou CMP et/ou gravure, ou bien de réaliser des interconnexions métalliques dans le substrat, ce qui est tout à fait raisonnable dans le cas d'un substrat silicium. On obtient ainsi des dispositifs GaN entièrement verticaux sans avoir à sacrifier un substrat GaN.

L'épitaxie locale du GaN peut en outre permettre de former des îlots de hauteur allant jusqu'à 10 µm voire 20 µm. Grâce à cela, les transistors formés par le procédé peuvent supporter des tensions aussi élevées que 1200V voire 2200V.

Par ailleurs, le procédé permet de fabriquer efficacement des dispositifs verticaux avec un très fort taux de couverture du substrat. Pour des îlots hexagonaux par exemple, la surface perdue du fait des écarts entre îlots est comprise entre 5 à 10% de la surface totale, ce qui est très faible.

Ainsi, le procédé selon l'invention permet une fabrication efficace, à grande échelle et peu coûteuse de dispositifs verticaux à base de GaN. Les dispositifs fabriqués sont par ailleurs très compacts et robustes.

### BREVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :
Les figures 1A à 1I illustrent un premier mode de réalisation du procédé selon l'invention permettant de fabriquer des diodes.
Les figures 1F et 1G illustrent un exemple dans lequel le substrat est retiré et le drain est formé au contact direct des îlots.
Les figures 1H et 1I illustrent un exemple dans lequel des interconnexions métalliques sont formées dans le substrat et le drain est formé au contact de ces interconnexions.
Les figures 2A à 2J illustrent un deuxième mode de réalisation du procédé selon l'invention permettant de fabriquer des transistors.
Les figures 3A à 3C sont des images obtenues par microscopie électronique à balayage (MEB) d'îlots de GaN crus par épitaxie localisée.
La figure 3B est un agrandissement de la figure 3A.
La figure 3C est un agrandissement de la figure 3B.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier les dimensions ne sont pas représentatives de la réalité.

### DESCRIPTION DÉTAILLÉE

Avant d'entamer une revue détaillée de modes de réalisation de l'invention, sont énoncées ci-après des caractéristiques optionnelles qui peuvent éventuellement être utilisées en association ou alternativement :
Selon un exemple, le substrat est à base de silicium.

Selon un exemple, chaque îlot présente une hauteur h₁₀₀ supérieure ou égale à 10 µm, de préférence supérieure ou égale à 20 µm, h₁₀₀ étant mesurée dans une direction perpendiculaire à un plan dans lequel la face supérieure du substrat s'étend principalement.

Selon un mode de réalisation, l'étape de formation du drain comprend les étapes suivantes :
- après formation de l'au moins un îlot, retirer le substrat, puis
- former le drain contre la face inférieure de l'au moins un îlot.

Selon un mode de réalisation, l'étape de formation du drain comprend les étapes suivantes :
- pour chaque îlot, former au moins une interconnexion métallique traversant le substrat et débouchant sur ledit îlot,
- former le drain contre une face inférieure du substrat opposée à sa face supérieure, le drain se trouvant en contact avec l'au moins une interconnexion métallique.

Selon un mode de réalisation particulier, le procédé selon l'invention est un procédé de fabrication d'au moins un transistor vertical et comprend en outre les étapes suivantes :
- au niveau de chaque îlot, implanter partiellement la première couche de manière à former au moins une paire de régions, dites sources, dopées de l'autre type parmi un dopage de type n et un dopage de type p, les sources d'une même paire de sources se trouvant dans des puits dopés distincts,
- former au moins une grille en contact avec les deux sources d'une même paire de sources, l'au moins une grille comprenant un motif électriquement conducteur,
- former un contact électriquement conducteur dit contact source au contact de chaque source d'une même paire de sources.

Selon un exemple, la première couche forme au moins trois puits dopés et dans lequel au moins deux paires de sources sont formées dans ces au moins trois puits dopés, deux sources appartenant à des paires de sources distinctes étant formées dans un même puits dopé.

Selon un exemple, les contacts source en contact avec les sources formées dans un même puits dopé sont en continuité électrique et forment un contact source commun aux deux transistors.

Selon un exemple, l'étape de retrait du substrat est réalisée avant la formation du contact source, éventuellement avant la formation de la grille, éventuellement avant l'étape d'implantation et de formation des sources.

Selon un exemple, l'étape de retrait du substrat est réalisée après l'étape d'implantation et de formation des sources, éventuellement après la formation de la grille, éventuellement après la formation du contact source.

Selon un mode de réalisation, l'étape de formation de la première couche comprend les étapes suivantes :
- au niveau de chaque îlot, former dans la couche de migration au moins une ouverture s'étendant depuis la face supérieure de la couche de migration,
- au niveau de chaque îlot, former la première couche dans chacune des ouvertures dans la couche de migration de l'îlot, la première couche formant ainsi la pluralité de puits dopés.

Selon un mode de réalisation, l'étape de formation de la première couche comprend les étapes suivantes :
- au niveau de chaque îlot, former sur la couche de migration une couche continue de GaN dopé du premier type,
- au niveau de chaque îlot, former dans la couche continue de GaN des ouvertures secondaires séparées les unes des autres et traversant entièrement ladite couche continue de GaN dopé, de manière à mettre à jour partiellement la couche de migration, les portions restantes de la couche continue formant la première couche,
- au niveau de chaque îlot, faire croître par épitaxie la couche de migration dans les ouvertures secondaires.

Selon un mode de réalisation particulier, le procédé selon l'invention est un procédé de fabrication d'au moins une diode et comprend en outre l'étape suivante :
- former un motif électriquement conducteur dit anode en contact avec au moins deux puits dopés, de préférence avec tous les puits dopés.

Selon un exemple, l'étape de retrait du substrat est réalisée avant la formation de l'anode.

Selon un exemple, l'étape de retrait du substrat est réalisée après la formation de l'anode.

Il est précisé que, dans le cadre de la présente invention, les termes « sur », « surmonte », « recouvre », « sous-jacent », en « vis-à-vis » et leurs équivalents ne signifient pas forcément « au contact de ». Ainsi par exemple, le dépôt, le report, le collage, l'assemblage ou l'application d'une première couche sur une deuxième couche, ne signifie pas obligatoirement que les deux couches sont directement au contact l'une de l'autre, mais signifie que la première couche recouvre au moins partiellement la deuxième couche en étant, soit directement à son contact, soit en étant séparée d'elle par au moins une autre couche ou au moins un autre élément.

Une couche peut par ailleurs être composée de plusieurs sous-couches d'un même matériau ou de matériaux différents.

On entend par un substrat, une couche, un dispositif, « à base » d'un matériau M, un substrat, une couche, un dispositif comprenant ce matériau M uniquement ou ce matériau M et éventuellement d'autres matériaux, par exemple des éléments d'alliage, des impuretés ou des éléments dopants.

On entend par « gravure sélective vis-à-vis de » ou « gravure présentant une sélectivité vis-à-vis de » une gravure configurée pour enlever un matériau A ou une couche A vis-à-vis d'un matériau B ou d'une couche B, et présentant une vitesse de gravure du matériau A supérieure à la vitesse de gravure du matériau B. La sélectivité est le rapport entre la vitesse de gravure du matériau A sur la vitesse de gravure du matériau B. La sélectivité entre A et B est notée SA:B.

Deux éléments sont dits « reliés électriquement » lorsqu'ils sont chacun en contact avec un même élément de connexion électrique continu présentant une conduction électrique de préférence supérieure à 10⁷ S/m.

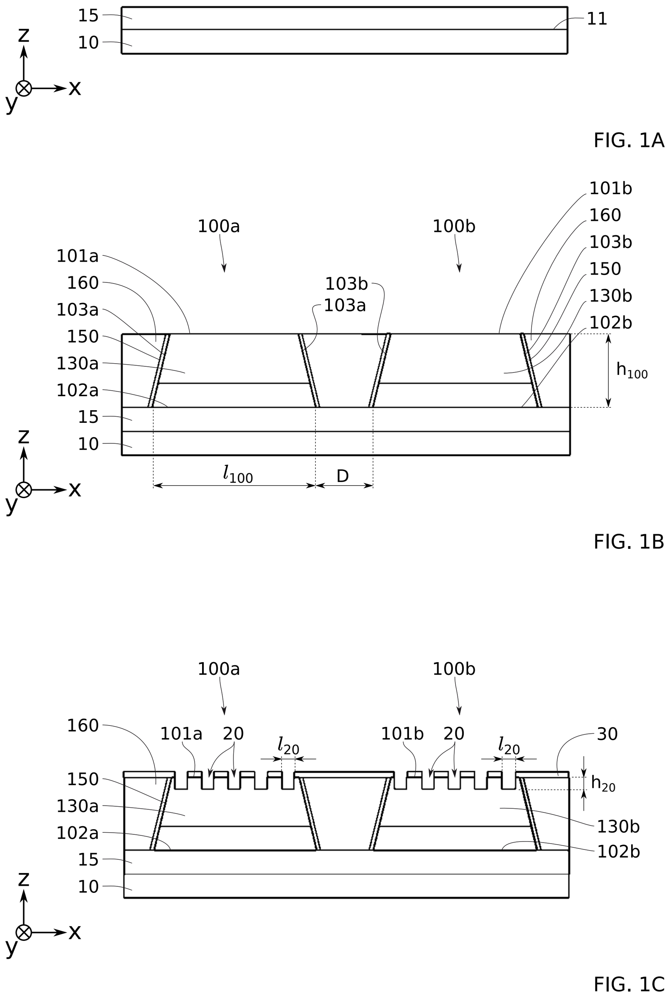

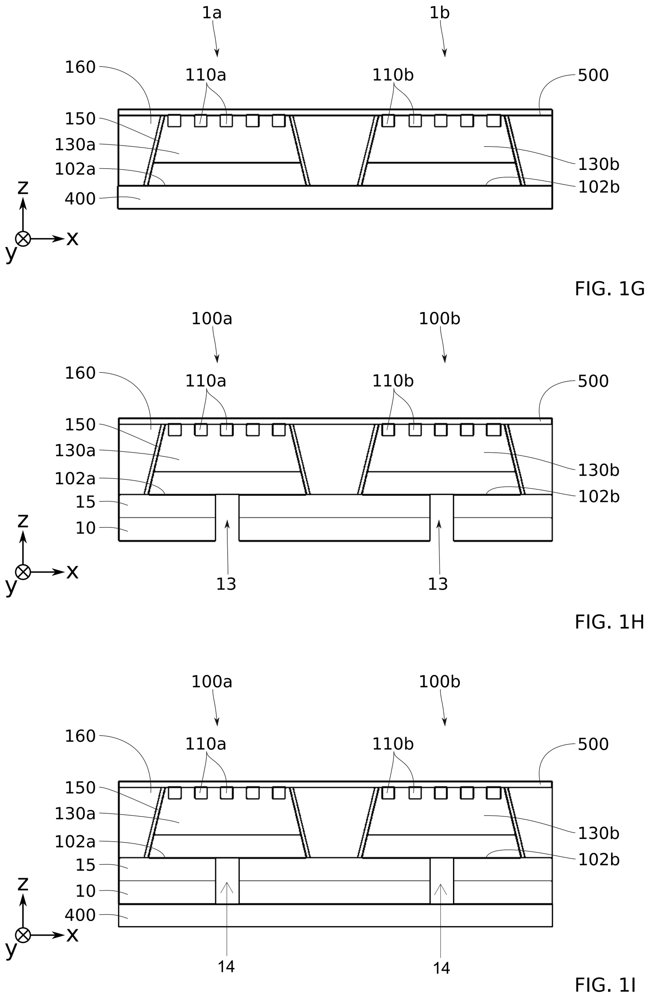

Un repère, de préférence orthonormé, comprenant les axes X, Y, Z est représenté en figures 1A, 2A et 3A. Ce repère est applicable par extension aux autres figures. La direction Z pourra être désignée « direction d'empilement ».

Dans la présente demande de brevet, on parlera préférentiellement d'épaisseur pour une couche et de hauteur pour une structure ou un dispositif. La hauteur est prise perpendiculairement au plan longitudinal XY. L'épaisseur est prise selon une direction normale au plan d'extension principal de la couche. Ainsi, une couche présente typiquement une épaisseur selon Z, lorsqu'elle s'étend principalement le long du plan longitudinal XY, et un élément en saillie, par exemple une tranchée d'isolation, présente une hauteur selon Z. Les termes relatifs « sur », « sous », « dessus », « dessous », « sous-jacent » se réfèrent préférentiellement à des positions prises selon la direction Z.

Les termes « sensiblement », « environ », « de l'ordre de » signifient « à 10% près, de préférence à 5% près ».

Un premier mode de réalisation du procédé selon l'invention permettant de fabriquer des diodes 1a, 1b va maintenant être décrit en référence aux figures 1A à 1G. Ces figures illustrent la formation simultanée de deux diodes 1a, 1b, mais il est entendu qu'un plus grand nombre de diodes peut être fabriqué simultanément par le procédé selon l'invention.

La figure 1A illustre la fourniture d'un substrat 10. Ce substrat 10 est typiquement à base de silicium. Il présente une face supérieure 11 s'étendant principalement dans un plan XY pouvant être désigné plan longitudinal XY. Ce plan est défini par une première direction X et une deuxième direction Y. Le substrat 10 présente en outre une face inférieure 12 opposée à sa face supérieure 11.

Avantageusement, des couches tampons 15 sont déposées sur la face supérieure 11 du substrat 10. Ces couches tampons 15 peuvent par exemple chacune être à base de l'un des matériaux suivants : GaN, AIN, AlGaN, BN.

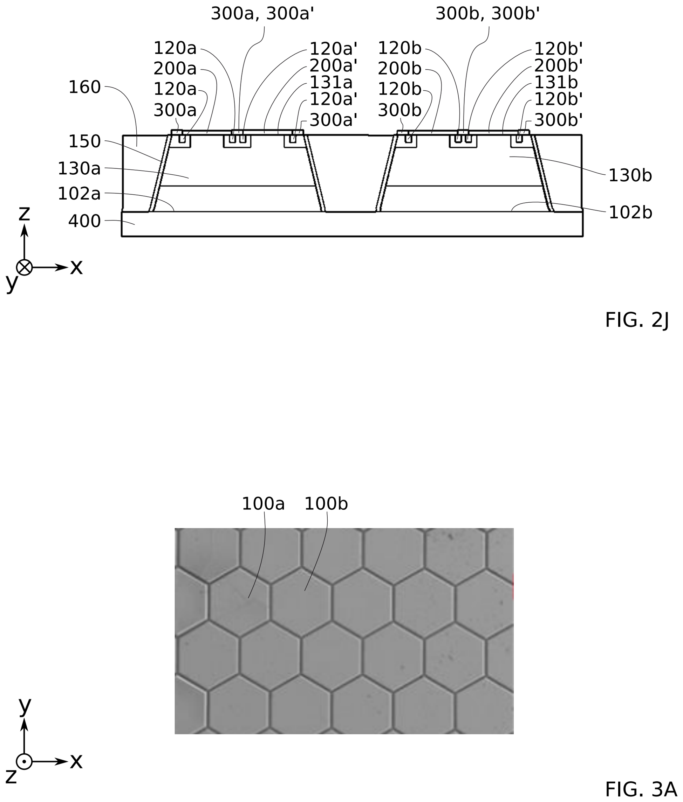

Comme illustré à la figure 1B, des îlots 100a, 100b à base de GaN sont ensuite crus localement par épitaxie sur la face supérieure 11 du substrat 10. Typiquement, ces îlots 100a, 100b sont crus à partir des couches tampons 15. La figure 3A illustre le résultat expérimental de cette étape : elle constitue une vue de dessus obtenue par MEB d'un ensemble d'îlots crus par épitaxie localisée sur un substrat silicium. On peut notamment apprécier sur cette image qu'un grand nombre d'îlots peuvent être crus simultanément par épitaxie localisée.

Les îlots 100a, 100b sont séparés les uns des autres. Ainsi, de préférence, on ne trouve aucune couche continue résiduelle de GaN sur la face supérieure 11 du substrat 10 (à l'exception d'éventuelles couches tampons pouvant comprendre du GaN).

Les îlots 100a, 100b présentent chacun une face inférieure 102a, 102b se trouvant en regard de la face supérieure 11 du substrat 10, et typiquement en contact avec les couches tampons 15. Ils présentent par ailleurs chacun une face supérieure 101a, 101b opposée à la face inférieure 102a, 102b.

L'étape d'épitaxie des îlots 100a, 100b de GaN est avantageusement configurée pour former des couches de GaN au sein de chaque îlots 100a, 100b présentant des dopages différents. Selon un exemple avantageux, les îlots 100a, 100b comprennent, depuis les faces inférieures 102a, 102b des îlots 100a, 100b vers leurs faces supérieures 101a, 101b, une couche de GaN dopé n+ et une couche de GaN dopée n-, pouvant être désignée couche de migration ou drift layer 130a, 130b.

De façon parfaitement classique, le dopant des couches dopées n peut être le silicium (Si) ou le germanium (Ge) et le dopant des couches dopées p le magnésium (Mg).

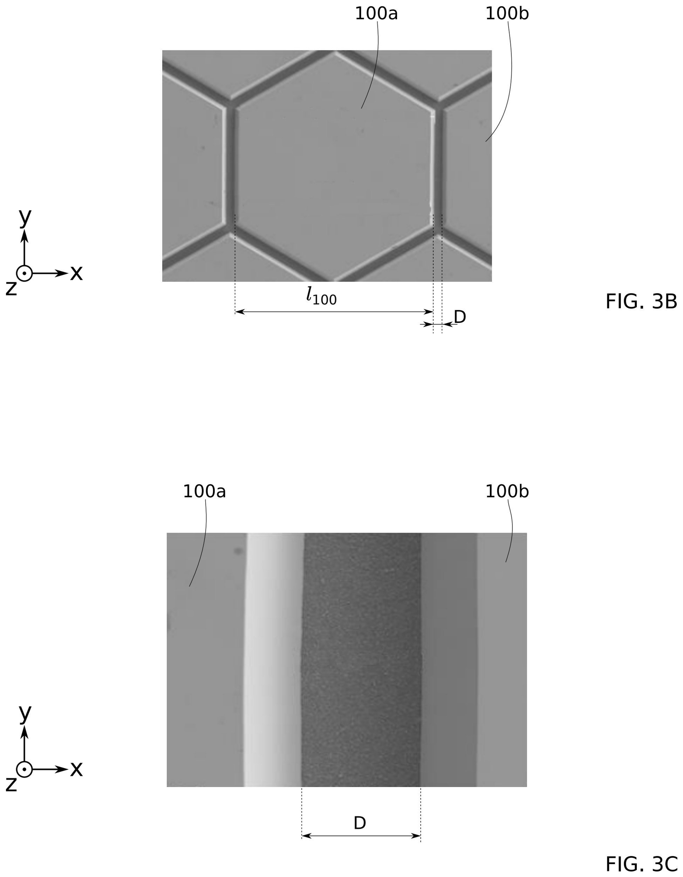

Les îlots 100a, 100b présentent une dimension caractéristique dans le plan XY notée l₁₀₀. En projection dans le plan XY, les îlots 100a, 100b présentent typiquement chacun une forme hexagonale, comme cela peut être observé sur la figure 3A. Dans ce cas, la dimension caractéristique l₁₀₀ correspond à la distance entre deux flancs de l'îlots 100a, 100b se faisant face. Sur la figure 3B, I₁₀₀ est par exemple mesurée selon la première direction X. I₁₀₀ est de préférence supérieure à 100 µm, et de préférence inférieure ou égale à 200 µm.

Les flancs latéraux 103a, 103b des îlots 100a, 100b sont typiquement inclinés par rapport à la direction d'empilement Z, comme illustré sur les figures. I₁₀₀ est alors mesurée à la base des îlots 100a, 100b, au niveau de leur face inférieure 102a, 102b.

Les îlots 100a, 100b présentent une hauteur h₁₀₀ mesurée selon la direction Z (également désignée direction d'empilement Z) perpendiculaire au plan longitudinal XY. La hauteur h₁₀₀ est de préférence supérieure à 10 µm voire 20 µm.

Dans le plan longitudinal XY, les îlots 100a, 100b sont séparés d'une distance D (prise selon la première direction X sur les figures 1B, 3B et 3C). D est mesurée au pied des îlots 100a, 100b, c'est-à-dire à la hauteur selon Z à laquelle se trouve les faces inférieures 102a, 102b des îlots 100a, 100b. La distance D est typiquement supérieure à 5 µm. La distance D est de préférence inférieure à 20 µm voire inférieure à 15 µm, voire à 10 µm. D est typiquement comprise entre 10 et 15 µm. Cela permet de fabriquer des dispositifs avec une meilleure densité. Elle est par exemple sensiblement égale à 8 µm.

Les valeurs numériques données ci-dessus sont également valables pour le deuxième mode de réalisation qui sera décrit plus avant.

Comme cela est également illustré sur la figure 1B, les flancs latéraux 103a, 103b des îlots 100a, 100b sont avantageusement recouverts d'une couche de passivation 150. La couche de passivation 150 est par exemple à base d'alumine ou de SiN.

Les espaces laissés vides entre les îlots 100a, 100b sont de préférence remplis par une couche de remplissage 160 à base d'un matériau diélectrique, par exemple à base de silice ou de tetraethyl orthosilicate (TEOS). Le dépôt de la couche de remplissage 160 peut se faire par dépôt chimique en phase vapeur (couramment désigné CVD, de l'anglais « chemical vapor deposition »). Avantageusement, ce dépôt se fait selon une méthode faible contrainte (« low stress » en anglais).

Le dépôt de la couche de remplissage 160 peut être suivi d'une étape de planarisation au niveau de la face supérieure 101a, 101b des îlots 100a, 100b.

Une étape de gravure est ensuite réalisée à partir des faces supérieures 101a, 101b des îlots 100a, 100b (figure 1C). Cette étape de gravure est configurée pour former au moins une ouverture 20, et de préférence une pluralité d'ouvertures 20, dans chaque îlot 100a, 100b. Chaque ouverture 20 traverse partiellement la couche de migration 130a, 130b. Comme cela apparaîtra plus avant, les dimensions des ouvertures 20 conditionnent celles des zones actives des diodes 1a, 1b. Les ouvertures 20 présentent par exemple une largeur l₂₀ selon la première direction X, avec l₂₀ comprise entre 100 nm et 4000 nm. Selon la deuxième direction Y, les ouvertures 20 peuvent traverser entièrement les îlots 100a, 100b. Les ouvertures 20 présentent en outre une hauteur h₂₀ selon la direction d'empilement Z. h₂₀ est typiquement supérieure ou égale à 400nm.

De façon parfaitement classique, cette étape de gravure peut être réalisée par une gravure sèche au travers d'une couche de masquage 30, comme illustré à la figure 1C. Pour cela, des étapes classiques de photolithographie pourront être employées. La couche de masquage 30 peut par exemple être en alumine, SiN, SiO₂ ou encore être une multicouche SiO₂/Al₂O₃.

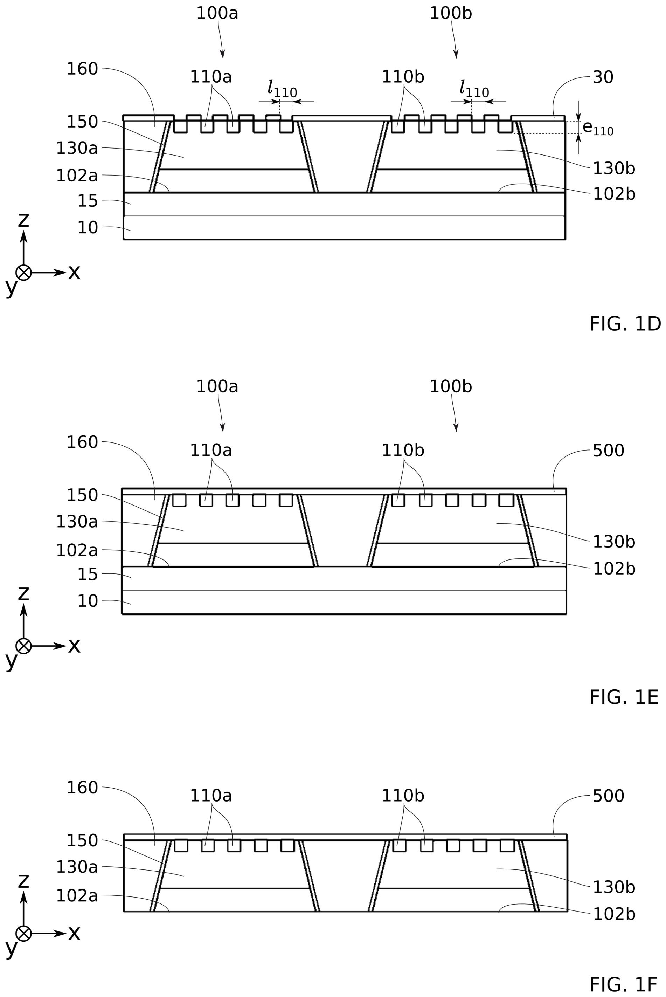

Lors d'une étape illustrée à la figure 1D, une première couche 110a, 110b est formée par épitaxie dans les ouvertures 20 de chaque îlot 100a, 100b. La première couche 110a, 110b est à base de GaN dopé. Son dopage peut être de type n ou de type p. La première couche 110a étant formée dans les ouvertures 20, elle est discontinue. Elle forme ainsi dans la couche de migration 130a, 130b des régions dopées séparées les unes des autres, dites puits dopés. La largeur l₁₁₀ de chaque puits dopé est sensiblement égale à la largeur l₂₀ des ouvertures 20. Il en va de même pour l'épaisseur e₁₁₀ des puits dopés, sensiblement égale à la hauteur h₂₀ des ouvertures 20.

Le dopage de la première couche 110a, 110b est de préférence réalisé lors de l'épitaxie de cette dernière. Cela permet une meilleure maîtrise de la concentration et de l'activation des dopants au sein de la première couche 110a, 110b. Il est cependant également envisageable de réaliser une épitaxie puis un dopage par implantation.

La couche de masquage 30 est ensuite retirée.

Selon un mode de réalisation alternatif non illustré, la première couche 110a, 110b peut être formée de la manière suivante, à partir de l'ensemble illustré en figure 1B. Une couche continue de GaN dopé n ou p est tout d'abord formée au-dessus de la couche de migration 130a, 130b de chaque îlot 100a, 100b. L'épaisseur de la couche continue est sensiblement égale à la hauteur des ouvertures 20 du mode de réalisation précédent, h₂₀. Une étape de gravure est ensuite réalisée dans cette couche continue. Cette étape de gravure est configurée pour former au moins une ouverture secondaire, et de préférence une pluralité d'ouvertures secondaires, dans la couche continue de GaN de chaque îlot 100a, 100b. La gravure est par ailleurs configurée pour que les ouvertures secondaires traversent entièrement la couche continue de GaN dopé, de manière à partiellement mettre à jour la couche de migration 130a, 130b sous-jacente. Cette étape de gravure peut être réalisées par des techniques classique de masquage et de photolithographie.

Les portions restantes, c'est-à-dire les portions non gravées, de la couche continue de GaN forment les puits dopés. Elles forment donc la première couche 110a, 110b. Les ouvertures secondaires sont donc dimensionnées de manière à ce que les puits dopés restants présentent les dimensions souhaitées. Une croissance par épitaxie est ensuite réalisée à partir de la couche de migration 130a, 130b dans les ouvertures secondaires. La couche de migration 130a, 130b est ainsi de préférence prolongée de manière être affleurante à la première couche 110a, 110b. On obtient ainsi l'ensemble illustré à la figure 1D (à l'exception de la couche de masquage 30).

Comme illustré à la figure 1E, un motif électriquement conducteur, désigné anode 500, est ensuite formé sur l'empilement. L'anode 500 est en contact avec au moins deux puits dopés d'un même îlot 100a, 100b. Avantageusement, elle est en contact avec tous les puits dopés d'un même îlot 100a, 100b. Selon un mode de réalisation avantageux illustré à la figure 1E, l'anode s'étend de façon continue au-dessus d'une pluralité d'îlots 100a, 100b. Elle peut ainsi contacter tous les puits dopés de ces îlots 100a, 100b, comme illustré.

Comme illustré à la figure 1F, il est ensuite possible de procéder au retrait du substrat 10 et des éventuelles couches tampons 15. Ce retrait est typiquement effectué par meulage et polissage mécanochimique (couramment désigné CMP, de l'anglais « chemical-mechanical polishing »). Avantageusement, une majeure partie du retrait est effectuée par meulage et CMP, puis le retrait est finalisé par gravure sélective ou gravure au temps pour s'arrêter précisément sur la face inférieure 102a, 102b des îlots 100a, 100b.

Avantageusement, le retrait du substrat 10 et des couches tampon 15 intervient après le report des îlots 100a, 100b sur un substrat-poignée (non représenté). Ce report intervient du côté de la face supérieure 101a, 101b des îlots 100a, 100b. Le substrat-poignée est retiré après la formation du drain 400 décrite plus avant.

Le retrait du substrat 10 et des couches tampons 15 peut également intervenir plus tôt dans le procédé. Le substrat 10 peut en effet être retiré après la formation des îlots 100a, 100b (et les optionnelles formations de la couche de passivation 150 et de la couche de remplissage 160), et avant la formation de la première couche 110a, 110b ou de l'anode 500, entre les étapes illustrées aux figures 1B et 1C, 1C et 1D ou 1E et 1D. Cela permet de réduire les contraintes mécaniques au sein de l'empilement lors de la formation de la première couche 110a, 110b et de l'anode 500.

Après le retrait du substrat 10, on procède à la formation d'une couche électriquement conductrice dite drain 400 au contact des faces inférieures 102a, 102b des îlots 100a, 100b. Ce drain 400 s'étend de façon continue sous les îlots 100a, 100b. Il est ainsi commun à toutes les diodes 1a, 1b. La formation du drain 400 est typiquement réalisée par dépôt métallique électrochimique.

Selon un autre exemple, après le retrait du substrat 10 et des couches tampons 15, on reporte les îlots 100a, 100b par leurs faces inférieures 102a, 102b sur une plaque de silicium fortement dopée selon un dopage de type n. Avantageusement, le report se fait par l'intermédiaire de couches métalliques favorisant le collage et/ou la conduction électrique entre les îlots 100a, 100b et la plaque de silicium, telles que des couches à base de Ti, Au et/ Al. Le drain 400 est ensuite déposé en face arrière de la plaque de silicium, à l'opposé des îlots 100a, 100b.

Selon un mode de réalisation alternatif illustré aux figures 1H et 1I, plutôt que de retirer le substrat 10 et les couches tampons 15, des interconnexions métalliques sont réalisées. Ainsi, il est possible, comme illustré en figure 1H, de réaliser par gravure des ouvertures traversantes 13 traversante entièrement le substrat 10 et éventuellement les couches tampons 15. Les ouvertures traversantes 13 s'étendent ainsi notamment de la face supérieure 11 à la face inférieure 12 du support. On forme au moins une ouverture traversante 13 en regard de chaque îlot 100a, 100b. Les ouvertures traversantes 13 sont typiquement formées par un procédé de photolithographie et gravure. Les ouvertures traversantes 13 sont ensuite remplies d'un matériau électriquement conducteur, typiquement un métal, de manière à former des interconnexions métalliques 14 traversant également le substrat 10 et les couches tampons 15. Le drain 400 est alors formé contre la face inférieure 12 du substrat 10 (figure 1I). Le drain 400 est formé au contact d'au moins une interconnexion métallique 14, de préférence de toutes les interconnexions métalliques 14. Les interconnexions métalliques 14 assurent la connexion électrique entre le drain 400 et les îlots 100a, 100b.

Le procédé permet ainsi de former au moins une diode 1a, 1b, chacune formée des éléments suivants :
- Le drain 400, ou du moins une portion de ce drain 400,
- Un îlot 100a, 100b, comprenant des couches de GaN aux dopages distincts dont la couche de migration 130a, 130b et la première couche 110a, 110b (sous forme de puits dopés),
- Au moins une anode 500 déposée au contact de la première couche 110a, 110b de l'îlot 100a, 100b considéré, ou au moins une portion de cette anode 500.

La présence d'une pluralité de puits dopés au sein de chaque diode 1a, 1b permet d'augmenter leur puissance. Avantageusement, chaque diode 1a, 1b comprend au moins trois puits dopés, de préférence au moins cinq puits dopés.

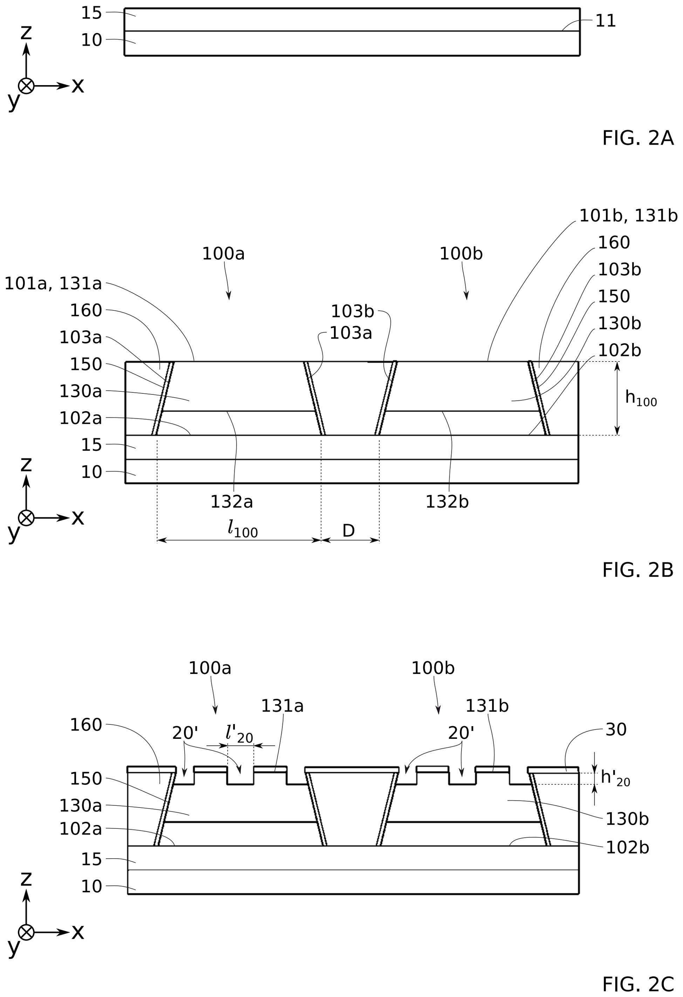

Un deuxième mode de réalisation permettant de fabriquer des transistors 2a, 2b va maintenant être décrit en référence aux figures 2A à 2J.

Le deuxième mode de réalisation peut par exemple débuter comme le premier mode de réalisation avec la fourniture d'un substrat 10 et avantageusement de couches tampons 15, comme illustré à la figure 2A, puis la formation d'îlots 100a, 100b, comme illustré à la figure 2B. Les caractéristiques décrites en référence aux figures 1A et 1B dans le cadre du premier mode de réalisation s'appliquent entièrement ici.

Une étape de gravure est ensuite réalisée à partir des faces supérieures 101a, 101b des îlots 100a, 100b. Cette étape de gravure est configurée pour former au moins deux ouvertures 20', et de préférence au moins trois ouvertures 20', dans chaque îlot 100a, 100b. Chaque ouverture 20' traverse partiellement la couche de migration 130a, 130b. Comme cela apparaîtra plus avant, les dimensions des ouvertures 20' conditionnent celles des zones actives des transistors 2a, 2b. Les ouvertures 20' présentent par exemple une largeur l₂₀' selon la première direction X, avec l₂₀' comprise entre 1500 nm et 5000 nm. Selon la deuxième direction Y, les ouvertures 20' traversent de préférence entièrement les îlots 100a, 100b. Dans ce cas, les ouvertures présentent dans le plan longitudinal XY une forme de bande. D'autres configurations sont cependant parfaitement envisageables. Les ouvertures 20' peuvent notamment présenter dans le plan longitudinal XY une forme carrée, circulaire ou hexagonale. Les ouvertures 20' peuvent être réparties dans le plan longitudinal XY selon un réseau carré ou bien un réseau hexagonal, notamment dans le cas d'ouvertures présentant elles-mêmes une forme hexagonale. Les ouvertures 20' présentent en outre une hauteur h₂₀' selon la direction d'empilement Z. Quelle que soit la forme des ouvertures 20' dans le plan longitudinal XY, h₂₀' est typiquement supérieure ou égale à 400 nm.

De façon parfaitement classique, cette étape de gravure peut être réalisée par une gravure sèche au travers d'une couche de masquage 30, comme illustré à la figure 2C. Pour cela, des étapes classiques de photolithographie pourront être employées.

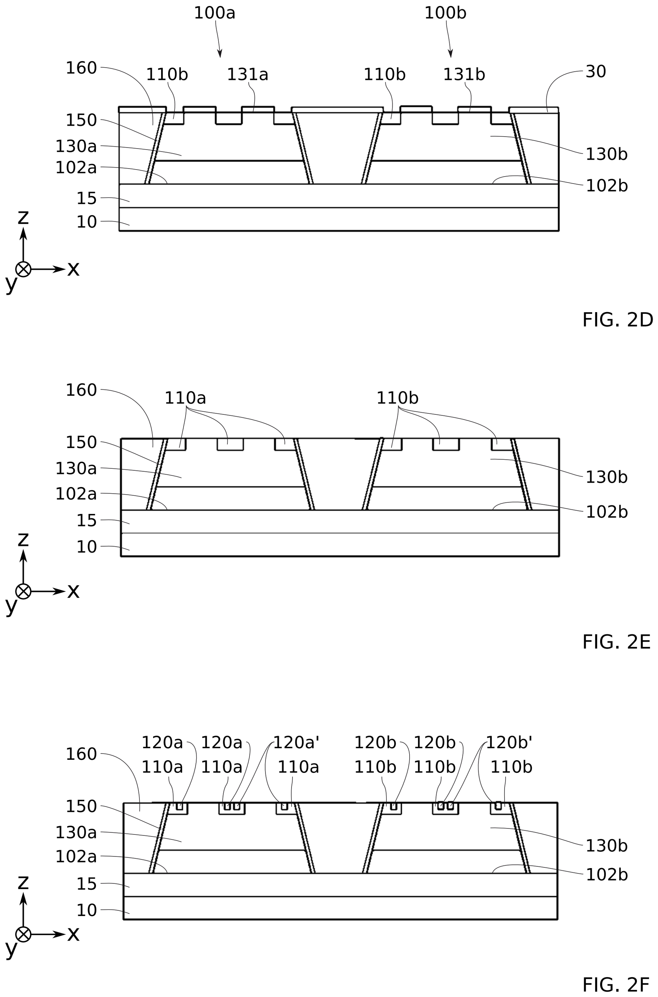

De façon similaire au premier mode de réalisation, lors d'une étape illustrée à la figure 2D, une première couche 110a, 110b est formée dans les ouvertures 20' de chaque îlot 100a, 100b. La première couche 110a, 110b est à base de GaN dopé. Son dopage, réalisé lors de l'épitaxie ou par implantation, peut être de type n ou de type p. La première couche 110a étant formée dans les ouvertures 20, elle est discontinue. Elle forme ainsi dans la couche de migration 130a, 130b des régions dopées séparées les unes des autres, dites puits dopés. La largeur l₁₁₀ de chaque puits dopé est sensiblement égale à la largeur l₂₀' des ouvertures 20' formées précédemment. Il en va de même pour l'épaisseur e₁₁₀ des puits dopés, sensiblement égale à la hauteur h₂₀' des ouvertures 20'.

La couche de masquage 30 est ensuite retirée (figure 2E).

Comme dans le premier mode de réalisation, alternativement, la formation de la première couche 110a, 110b peut passer par les étapes suivantes :
- Dépôt d'une couche continue de GaN dopé sur la couche de migration 130a, 130b,
- Formation d'ouvertures secondaires dans la couche continue de sorte à mettre partiellement à jour la couche de migration 130a, 130b,
- Croissance par épitaxie de la couche de migration 130a, 130b au travers des ouvertures secondaires.

On obtient alors l'ensemble illustré à la figure 2E.

On procède ensuite à une implantation localisée dans la première couche 110a, 110b (figure 2F). Cette implantation est configurée pour former au moins deux régions dopées, dites sources, formant une paire de sources 120a, 120a', 120b, 120b'. Au sein d'une paire de sources 120a, 120a', 120b, 120b', une première source se trouve dans un premier puits dopé et une deuxième source se trouve dans un deuxième puits dopé distinct du premier. Un même puits dopé peut accueillir plusieurs sources, de préférence deux sources. La figure 2F illustre par exemple, au niveau de chaque îlot 100a, 100b, deux paires de sources réparties dans trois puits dopés. L'implantation est avantageusement une implantation de type n, avec du silicium comme espèce implantée. Suite à l'implantation, on effectue de préférence un recuit d'activation. De préférence, le recuit d'activation est réalisé en présence d'une couche de protection surmontant la couche de migration 130a, 130b de manière à protéger le GaN. La couche de protection peut par exemple être à base de SiN, SiO₂ ou AIN.

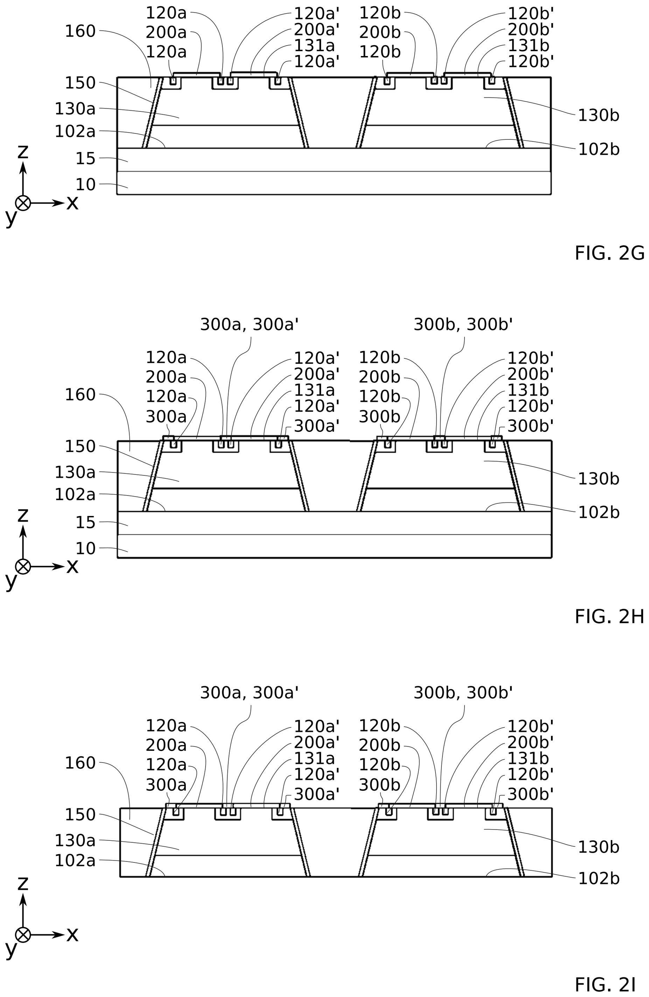

Comme illustré à la figure 2G, on forme ensuite sur chaque îlot 100a, 100b au moins un motif électriquement conducteur faisant partie d'une grille 200a, 200a', 200b, 200b'. Chaque grille 200a, 200a', 200b, 200b' est en contact avec les deux sources d'une même paire. Par exemple, sur les figures, la grille portant la référence 200a est en contact avec les sources référencées 120a. Il est entendu que chaque grille 200a, 200a', 200b, 200b' peut également comprendre un oxyde semi-conducteur (par exemple du SiO₂), dit oxyde de grille ou diélectrique de grille. L'oxyde de grille est au contact du motif électriquement conducteur. Les oxydes de grille sont typiquement formés à cette même étape.

On forme ensuite des contacts électriquement conducteurs dits contacts source 300a, 300a', 300b, 300b' en contact avec les sources 120a, 120a', 120b, 120b' (figure 2H). Comme illustré, un contact commun peut être formé entre sources se trouvant dans un même puis dopé. Cela crée un court-circuit entre les deux sources permettant d'éviter la création d'un transistor bipolaire conducteur en parallèle des transistors fabriqués 2a, 2b.

Les figures 2I et 2J illustrent le retrait du substrat 10 et des éventuelles couches tampon 15 et la formation d'un drain 400' au contact de la face inférieure 102a, 102b des îlots 100a, 100b. Ces étapes peuvent être réalisées de la même manière que ce qui a été décrit précédemment en référence au premier mode de réalisation. Elles peuvent intervenir à différents moments du procédé, par exemple entre la formation des îlots 100a, 100b et la formation de la première couche 110a, 110b, entre la formation de la première couche 110a, 110b et celle des sources 120a, 120a', 120b, 120b', entre la formation des sources 120a, 120a', 120b, 120b' et celle des grilles 200a, 200a', 200b, 200b', entre la formation des grilles 200a, 200a', 200b, 200b' et celle des contacts source 300a, 300a', 300b, 300b' ou encore après cette dernière.

Tout comme dans le premier mode de réalisation, il est également possible de réaliser des interconnexions métalliques dans le substrat 10 et dans les couches tampons 15 et de former le drain au contact de la face inférieure 12 du substrat 10.

Le procédé permet ainsi de former au moins un transistor 2a, 2b, chacun formé des éléments suivants :
- Le drain 400, ou du moins une portion de ce drain 400,
- Un îlot 100a, 100b, comprenant des couches de GaN aux dopages distincts dont la couche de migration 130a, 130b et la première couche 110a, 110b (sous forme de puits dopés),
- Au moins deux sources 120a, 120a', 120b, 120b',
- Au moins une grille 200a, 200a', 200b, 200b' reliant électriquement les deux sources,
- Des contacts sources 300a, 300a', 300b, 300b' contactant les sources.

Ainsi, au vu des différents modes de réalisation décrits ci-dessus, l'invention permet de fabriquer des dispositifs verticaux à base de GaN, notamment des transistors et des diodes, sans utiliser de substrat GaN, coûteux et souvent uniquement disponible dans de faibles dimensions.

L'invention n'est pas limitée aux modes de réalisations précédemment décrits et s'étend à tous les modes de réalisation couverts par l'invention.

## Revendications

1. Procédé de fabrication d'au moins un dispositif microélectronique (1a, 1b, 2a, 2b) comprenant les étapes suivantes :
• fournir un substrat (10) présentant une face supérieure (11),
• réaliser une épitaxie localisée de nitrure de gallium (GaN) sur la face supérieure (11) du substrat (10), de sorte à former au moins un îlot (100a, 100b) à base de GaN, chaque îlot (100a, 100b) présentant une face, dite inférieure (102a, 102b), tournée au regard de la face supérieure (11) du substrat (10), chaque îlot (100a, 100b) comprenant une couche dite de migration (130a, 130b) à base de GaN, la couche de migration (130a, 130b) présentant une face inférieure (132a, 132b) tournée au regard de la face supérieure (11) du substrat (10) et une face supérieure (131a, 131b) opposée à la face inférieure (132),
• au niveau de chaque îlot (100a, 100b), former une première couche (110a, 110b) à base de GaN dopé d'un premier type pris parmi un dopage de type n et un dopage de type p, la première couche (110a, 110b) formant une pluralité de puits dopés séparés les uns des autres et s'étendant chacun depuis la face supérieure (131a, 131b) de la couche de migration (130a, 130b),
• former une couche électriquement conductrice (400) formant un drain, le drain (400) étant relié électriquement à la face inférieure (102a, 102b) de chaque îlot (100a, 100b), formant ainsi au moins un transistor vertical (1a, 1b).

2. Procédé de fabrication selon la revendication précédente dans lequel le substrat (10) est à base de silicium.

3. Procédé de fabrication selon l'une quelconque des revendications précédentes dans lequel chaque îlot (100a, 100b) présente une hauteur h₁₀₀ supérieure ou égale à 10 µm, de préférence supérieure ou égale à 20 µm, h₁₀₀ étant mesurée dans une direction perpendiculaire à un plan (XY) dans lequel la face supérieure (11) du substrat (10) s'étend principalement.

4. Procédé de fabrication selon l'une quelconque des revendications précédentes dans lequel l'étape de formation du drain (400) comprend les étapes suivantes :
• après formation de l'au moins un îlot (100a, 100b), retirer le substrat (10), puis
• former le drain (400) contre la face inférieure (102a, 102b) de l'au moins un îlot (100a, 100b).

5. Procédé de fabrication selon l'une quelconque des revendications 1 à 3 dans lequel l'étape de formation du drain (400) comprend les étapes suivantes :
• pour chaque îlot (100a, 100b), former au moins une interconnexion métallique traversant le substrat (10) et débouchant sur ledit îlot (100a, 100b),
• former le drain (400) contre une face inférieure (12) du substrat (10) opposée à sa face supérieure (11), le drain (400) se trouvant en contact avec l'au moins une interconnexion métallique.

6. Procédé de fabrication selon l'une quelconque des revendications précédentes dans lequel l'étape de formation de la première couche (110a, 110b) comprend les étapes suivantes :
• au niveau de chaque îlot (100a, 100b), former dans la couche de migration (130a, 130b) au moins une ouverture (20, 20') s'étendant depuis la face supérieure (131a, 131b) de la couche de migration (130a, 130b),
• au niveau de chaque îlot (100a, 100b), former la première couche (110a, 110b) dans chacune des ouvertures (20, 20') dans la couche de migration (130a, 130b) de l'îlot (100a, 100b), la première couche (110a, 110b) formant ainsi la pluralité de puits dopés.

7. Procédé de fabrication selon l'une quelconque des revendications 1 à 5 dans lequel l'étape de formation de la première couche (110a, 110b) comprend les étapes suivantes :
• au niveau de chaque îlot (100a, 100b), former sur la couche de migration (130a, 130b) une couche continue de GaN dopé du premier type,
• au niveau de chaque îlot (100a, 100b), former dans la couche continue de GaN des ouvertures secondaires séparées les unes des autres et traversant entièrement ladite couche continue de GaN dopé, de manière à mettre à jour partiellement la couche de migration (130a, 130b), les portions restantes de la couche continue formant la première couche (110a, 110b),
• au niveau de chaque îlot (100a, 100b), faire croître par épitaxie la couche de migration (130a, 130b) dans les ouvertures secondaires.

8. Procédé de fabrication d'au moins un transistor vertical (2a, 2b) mettant en œuvre le procédé selon l'une quelconque des revendications précédentes, comprenant en outre les étapes suivantes :
• au niveau de chaque îlot (100a, 100b), implanter partiellement la première couche (110a, 110b) de manière à former au moins une paire de régions, dites sources (120a, 120a', 120b, 120b'), dopées de l'autre type parmi un dopage de type n et un dopage de type p, les sources d'une même paire de sources (120a, 120a' ; 120b, 120b') se trouvant dans des puits dopés distincts,
• former au moins une grille (200a, 200a', 200b, 200b') en contact avec les deux sources d'une même paire de sources (120a, 120a' ; 120b, 120b'), l'au moins une grille (200a, 200a', 200b , 200b') comprenant un motif électriquement conducteur,
• former un contact électriquement conducteur dit contact source (300a, 300a', 300b, 300b') au contact de chaque source d'une même paire de sources (120a, 120a' ; 120b, 120b').

9. Procédé selon la revendication précédente dans lequel la première couche (110a, 110b) forme au moins trois puits dopés et dans lequel au moins deux paires de sources (120a, 120a' ; 120b, 120b') sont formées dans ces au moins trois puits dopés, deux sources appartenant à des paires de sources distinctes étant formées dans un même puits dopé.

10. Procédé selon la revendication précédente dans lequel les contacts source (300a, 300a' ; 300b, 300b') en contact avec les sources (120a, 120a', 120b, 120b') formées dans un même puits dopé sont en continuité électrique et forment un contact source commun aux deux transistors (2a, 2b).

11. Procédé de fabrication selon l'une quelconque des revendications 8 à 10 dans leur rattachement avec la revendication 4 dans lequel l'étape de retrait du substrat (10) est réalisée avant la formation du contact source (300a, 300a', 300b, 300b'), éventuellement avant la formation de la grille (200a, 200a', 200b, 200b'), éventuellement avant l'étape d'implantation et de formation des sources (120a, 120a', 120b, 120b').

12. Procédé de fabrication selon l'une quelconque des revendications 8 à 10 dans leur rattachement avec la revendication 4 dans lequel l'étape de retrait du substrat (10) est réalisée après l'étape d'implantation et de formation des sources (120a, 120a', 120b, 120b'), éventuellement après la formation de la grille (200a, 200a', 200b, 200b'), éventuellement après la formation du contact source (300a, 300a', 300b, 300b').

13. Procédé de fabrication d'au moins une diode (1a, 1b) mettant en œuvre le procédé selon l'une quelconque des revendications 1 à 7, comprenant en outre l'étape suivante :
• former un motif électriquement conducteur dit anode (500) en contact avec au moins deux puits dopés, de préférence avec tous les puits dopés.

14. Procédé de fabrication selon la revendication précédente dans son rattachement avec la revendication 4 dans lequel l'étape de retrait du substrat (10) est réalisée avant la formation de l'anode (500).

15. Procédé de fabrication selon l'une quelconque des deux revendications précédentes dans leur rattachement avec la revendication 4 dans lequel l'étape de retrait du substrat (10) est réalisée après la formation de l'anode (500).
